# FASCICULE DE BREVET EUROPEEN

(11) **EP 2 244 168 B1**
(45) Date de publication et mention de la délivrance du brevet: **05.05.2021**
(21) Numéro de dépôt: 10004040.1
(22) Date de dépôt: 16.04.2010
(51) Int. Cl.: G06F 3/01, H01H 13/85, G06F 3/041

(54) **Dispositif de commande à retour haptique et actionneur correspondant**
Steuervorrichtung mit haptischer Rückkopplung und entsprechendes Stellglied
Control device with haptic feedback and corresponding actuator

(30) Priorité: 20.04.2009 FR 0901902
(43) Date de publication de la demande: 27.10.2010
(73) Titulaire: DAV, 94000 Creteil (FR)
(72) Inventeur: Marie, Bruno, 74380 Cranves Sales (FR)

(56) Documents cités:
- WO-A1-99/66997
- WO-A2-2009/130188
- US-A- 5 189 660
- US-A1- 2005 017 947
- US-A1- 2006 290 662
- US-B1- 6 982 696

## Description

La présente invention concerne un dispositif de commande pour véhicule automobile, permettant notamment de transmettre un retour haptique à un utilisateur, tel qu'un retour vibratoire. L'invention concerne également un actionneur configuré pour être monté dans un tel dispositif de commande.

Dans le domaine automobile, des dispositifs de commande multifonction, réalisés par exemple sous la forme d'un joystick ou d'un bouton rotatif, sont de plus en plus utilisés pour commander des systèmes électriques ou électroniques, tels qu'un système de climatisation, un système audio ou encore un système de navigation.

De tels dispositifs peuvent être associés à un écran d'affichage et permettre une navigation dans des menus déroulants comportant différentes commandes relatives aux systèmes à commander.

Pour augmenter le confort ergonomique, l'utilisation d'une technologie à capteur à surface tactile au niveau de la surface de commande de tels dispositifs de commande peut être considérée comme un développement intéressant.

Lorsqu'un utilisateur exerce une pression sur la surface tactile d'un tel capteur, on peut mesurer la pression appliquée et/ou déterminer la localisation de l'endroit où la pression est exercée par application d'une tension électrique adaptée. Dans ce cas, un appui de l'utilisateur sur la surface tactile est par exemple associé à la sélection d'une commande.

En outre, pour signaler à l'utilisateur que sa commande a bien été prise en compte, notamment en conduite de nuit ou lors d'une manipulation en aveugle, il est important que l'utilisateur ait un retour haptique de manière à rester concentré sur la route.

Pour cela, on connaît déjà des dispositifs de commande à retour haptique comportant des actionneurs, tels que des actionneurs électromagnétiques, reliés à une plaque du capteur à surface tactile pour transmettre un mouvement de vibration à la plaque, de manière que l'utilisateur perçoive un retour haptique l'informant que sa commande a bien été prise en compte Les documents US 2005/017947 A1, US 6 982 696 B1, US 5 189 660 A, WO 99/66997 A1 et US 2006/290662 A1 décrivent de tels dispositifs de commande à retour haptique.

En particulier, US 2005/017947 A1 propose un dispositif dans lequel une unité de traitement est configurée pour piloter indépendamment chaque actionneur et fournir à chaque actionneur un signal d'alimentation périodique.

Le document US 2006/290662 A1, quant à lui, enseigne que plusieurs signaux de commande peuvent être utilisés pour piloter chacun un actuateur d'un dispositif d'entrée de données, lesdits signaux différant les uns des autres et, en particulier, étant déphasés.

Toutefois pour augmenter la puissance mécanique du mouvement de vibration, il est nécessaire d'augmenter la consommation d'énergie.

En outre, dans le cas d'une vibration générée dans le plan vertical par rapport à la plaque, les actionneurs supportent la plaque mais également l'effort de pression exercé sur cette plaque lors d'une commande de l'utilisateur, ce qui nécessite également une consommation accrue d'énergie.

L'invention a donc pour objectif de proposer un dispositif de commande à retour haptique amélioré ne présentant pas les inconvénients de l'art antérieur.

À cet effet, l'invention a pour objet un dispositif de commande à retour haptique comportant :
- une plaque pour transmettre un retour haptique à un utilisateur,
- un capteur à surface tactile porté par ladite plaque, configuré pour détecter un appui de l'utilisateur sur la surface tactile,
- au moins deux actionneurs reliés à ladite plaque et configurés pour entraîner ladite plaque en mouvement de manière à générer le retour haptique, et
- une unité de traitement reliée audit capteur pour piloter simultanément lesdits actionneurs lorsqu'un appui est détecté sur ladite surface tactile,
caractérisé en ce que lesdits actionneurs sont respectivement configurés pour entraîner ladite plaque selon une direction sensiblement perpendiculaire au plan défini par ladite plaque et en ce que l'unité de traitement est configurée pour piloter indépendamment chaque actionneur en fournissant à chaque actionneur un signal d'alimentation périodique, lesdits signaux d'alimentation étant déphasés de 180° de sorte que les dits actionneurs entraînent simultanément ladite plaque dans deux directions opposées.

Le pilotage indépendant des deux actionneurs dans le plan vertical par rapport à la plaque permet d'adapter le pilotage de chaque actionneur pour amplifier le retour haptique ressenti par l'utilisateur, sans augmenter la consommation d'énergie.

Le dispositif de commande peut en outre comporter une ou plusieurs caractéristiques suivantes, prises séparément ou en combinaison :
- l'unité de traitement est configurée pour piloter indépendamment lesdits actionneurs en fonction de la position de l'appui détecté par ledit capteur,
- ledit dispositif comporte un amortisseur entre ladite plaque et un châssis fixe dudit dispositif, pour amortir le mouvement de ladite plaque selon ladite direction perpendiculaire,
- au moins un actionneur est électromagnétique et comporte une partie fixe et une partie mobile reliée à ladite plaque, lesdites parties fixe et mobile formant un circuit magnétique définissant au moins un entrefer entre lesdites parties fixe et mobile,
- ledit actionneur comporte un moyen de liaison élastique dans l'entrefer entre lesdites parties fixe et mobile,
- ledit actionneur comporte en outre :
   - au moins deux aimants permanents générant un premier et un second champs magnétiques opposés, et
   - une bobine disposée entre lesdits aimants telle que l'enroulement de la bobine traverse successivement lesdits premier et second champs magnétiques,
   de sorte que lorsque la bobine est parcourue par un courant, ledit actionneur est soumis à une force résultante d'actionnement selon une direction d'entraînement commune pour entraîner ladite partie mobile en translation dans ledit entrefer,
- la partie dudit actionneur portant lesdits aimants présente une forme générale sensiblement en E, dont les branches extérieures portent respectivement un aimant permanent et dont la branche centrale forme un support pour l'enroulement de la bobine,
- la partie dudit actionneur portant la bobine présente une ouverture dans laquelle s'engage ladite branche centrale.

L'invention a également pour objet un actionneur correspondant destiné à être monté dans un tel dispositif de commande à retour haptique.

D'autres caractéristiques et avantages de l'invention ressortiront de la description suivante, donnée à titre d'exemple, sans caractère limitatif, en regard des dessins annexés sur lesquels :
- la figure 1 représente un premier mode de réalisation d'un dispositif de commande selon l'invention,
- la figure 2 est un schéma représentant des éléments du dispositif de commande de la figure 1,
- la figure 3 représente un second mode de réalisation d'un dispositif de commande selon l'invention,
- la figure figure 4a illustre un actionneur du dispositif de commande de la figure 3,
- la figure 4b est une vue en perspective de l'actionneur de la figure 4a, et
- la figure 5 représente un troisième mode de réalisation d'un dispositif de commande selon l'invention.

L'invention concerne un dispositif de commande à retour haptique, par exemple pour un tableau de commande de véhicule automobile, ou encore pour console centrale de véhicule automobile, permettant de commander des systèmes électriques ou électroniques du véhicule, et pouvant transmettre un retour haptique à un utilisateur ayant par exemple modifié ou sélectionné une commande.

Le retour haptique, par exemple de type vibratoire, permet d'assurer à l'utilisateur la prise en compte de la commande modifiée ou sélectionnée.

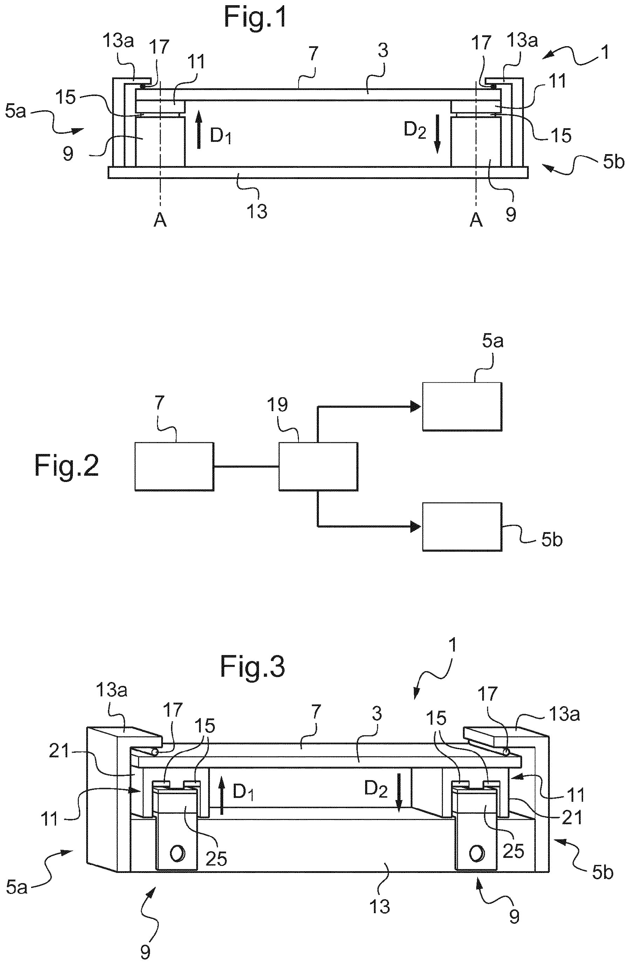

La figure 1 représente un tel dispositif de commande 1 comportant une plaque 3 pour transmettre un retour haptique à un utilisateur et deux actionneurs 5a,5b reliés à la plaque 3 pour générer le retour haptique.

La plaque 3 porte un capteur 7 à surface tactile, par exemple un capteur de pression utilisant la technologie FSR pour "Force Sensing Resistor" en anglais, c'est-à-dire utilisant des résistances sensibles à la pression. Ce capteur 7 permet de détecter un appui, par exemple d'un doigt de l'utilisateur, sur la surface tactile.

On peut également choisir un capteur utilisant une technologie capacitive ou optique pour détecter un appui de l'utilisateur.

Une peau de protection et de décoration (non représentée) peut être disposée sur le capteur 7 à surface tactile.

Les deux actionneurs 5a,5b sont disposés l'un en regard de l'autre. Pour une meilleure répartition des efforts appliqués à la plaque 3, ces actionneurs 5a,5b sont disposés au niveau de deux côtés opposés de la plaque 3.

Selon le premier mode de réalisation illustré sur la figure 1, chaque actionneur 5a,5b est électromagnétique et comprend une partie fixe 9 et une partie mobile 11 reliée à la plaque 3.

La partie fixe 9 comprend par exemple une bobine qui génère un champ électromagnétique lorsqu'elle est alimentée, et peut être réalisée en acier.

De plus, la partie fixe 9 est disposée en regard de la partie mobile 11 correspondante de manière à délimiter un entrefer e entre la partie fixe 9 et la partie mobile 11.

On peut prévoir des trous taraudés sur la partie fixe 9 pour coopérer avec des moyens de fixations complémentaires d'un châssis 13 fixe du dispositif 1. Bien entendu, on peut envisager d'autre moyens de fixation de la partie fixe 9 sur le châssis 13.

La partie mobile 11 peut être réalisée en matériau ferromagnétique, et est dirigée en translation dans l'entrefer e par le champ magnétique généré par la bobine 9 alimentée.

Chaque actionneur 5a,5b est disposé selon un axe d'entraînement A sensiblement perpendiculaire au plan défini par la plaque 3. Ainsi, chaque actionneur 5a,5b peut entraîner la plaque 3 en mouvement selon une direction D1 ou D2 sensiblement perpendiculaire au plan défini par la plaque 3.

En outre, pour chaque actionneur 5a,5b, un élément élastique 15 peut être agencé dans l'entrefer e, pour guider le mouvement de la partie mobile 11. L'élément élastique 15 amortit le mouvement de la partie mobile 11 et évite tout contact physique entre la partie fixe 9 et la partie mobile 11, limitant ainsi le bruit généré lors du mouvement de la partie mobile 11.

Cet élément élastique 15 peut être en élastomère ou en silicone et peut être surmoulé sur la partie fixe 9 et la partie mobile 11.

De manière à être compatible aux normes automobiles, pour lesquelles les retours haptiques dans un tel dispositif de commande 1 nécessitent de très petits déplacements, l'élément élastique 15 présente une épaisseur de l'ordre de 0.2 à 0.5 mm.

Avec cette configuration, les actionneurs 5a,5b forment également un moyen de maintien de la plaque 3.

Par ailleurs, on peut prévoir un moyen d'étanchéité 17 interposé entre la plaque 3 et une partie 13a du châssis 13. Ce moyen d'étanchéité 17 peut par exemple être réalisé en matériau élastique, tel qu'en élastomère ou en silicone. Ce moyen d'étanchéité 17 forme également un amortisseur du mouvement de la plaque selon la direction D1 ou D2.

Ainsi, le mouvement de la plaque 3 selon la direction D1 ou D2, est délimité d'une part par l'élément élastique 15 entre les parties fixe 9 et mobile 11 des actionneurs 5a et 5b, et d'autre part par le moyen d'étanchéité 17.

Comme mieux visible sur la figure 2, le dispositif 1 comporte en outre une unité de traitement 19 reliée au capteur 7 et aux actionneurs 5a,5b pour fournir un signal de commande à chaque actionneur 5a,5b de façon à entraîner la plaque 3 en mouvement, lorsqu'un appui est détecté sur la surface tactile. Le signal de commande peut être carré ou sinusoïdal.

Selon l'invention, l'unité de traitement 19 est configurée pour piloter indépendamment chaque actionneur 5a,5b. Cette unité 19 peut par exemple piloter les actionneurs 5a,5b en fonction de la position de l'appui détecté sur la surface tactile, plus précisément en fonction de signaux de position issus du capteur 7.

Plus précisément, l'unité 19 peut fournir un signal d'alimentation périodique à chaque actionneur 5a,5b, les signaux d'alimentation étant déphasés.

Selon l'invention, les signaux d'alimentation sont déphasés de 180° de sorte que lorsque l'actionneur 5a dirige la plaque 3 dans la direction D1, l'actionneur 5b dirige la plaque 3 dans la direction D2 opposée à la direction D1 (voir figure 1).

Un tel pilotage en opposition de phase des deux actionneurs 5a,5b joue un effet bascule qui permet pratiquement de doubler l'accélération et donc d'amplifier la perception du retour haptique par l'utilisateur sans augmenter la consommation d'énergie. De plus étant donnée la faible course de déplacement de la partie mobile 11, l'utilisateur ressent un retour haptique uniforme malgré l'effet bascule.

On peut prévoir un nombre pair d'actionneurs disposés en vis-à-vis deux à deux et dont les signaux d'alimentation sont inversés deux à deux.

Selon une alternative, l'unité 19 peut également commander l'application de niveaux de tension différents aux bornes de chaque actionneur 5a,5b.

Bien entendu, lors d'un déplacement du doigt sur la surface tactile, on peut prévoir que l'unité 19 adapte les signaux de commande, et donc le déphasage, en fonction de la position du doigt sur la surface tactile.

Selon un exemple de réalisation, le retour haptique peut être généré premièrement avec un pilotage en opposition de phase selon deux directions opposées, puis par un pilotage simultané selon une direction commune lorsque le doigt arrive au centre de la surface tactile, et inversement.

Un second mode de réalisation du dispositif de commande 1 est illustré sur la figure 3. Dans ce second mode de réalisation, la partie mobile 11 de l'actionneur 5a,5b comporte une structure ferromagnétique 21, par exemple en fer doux, qui porte deux aimants 23a,23b et la partie fixe 9 porte une bobine 25 disposée entre les deux aimants 23a,23b.

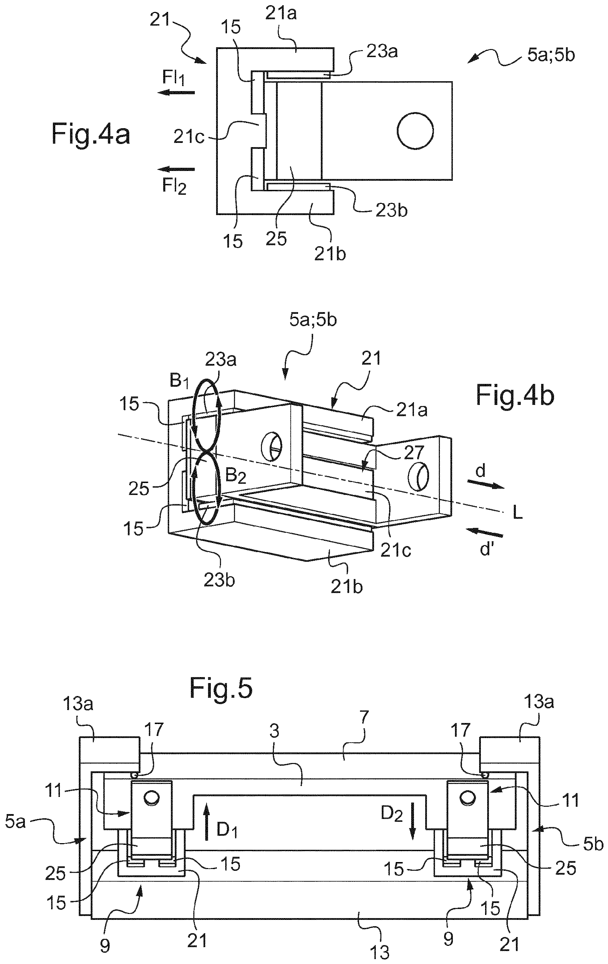

Les deux aimants 23a,23b, mieux visibles sur les figures 4a,4b, sont des aimants permanents de même polarité, et sont disposés en vis-à-vis de manière à générer deux champs magnétiques opposés B1 et B2.

Dans l'exemple illustré, la structure 21 présente une forme générale sensiblement en E, avec deux branches extérieures 21a,21b et une branche centrale 21c.

Dans ce cas, on prévoit un élément élastique 15 entre chaque branche extérieure 21a,21b et la branche centrale 21c. Chaque élément élastique 15 étant toujours entre la partie fixe 9 et la partie mobile 11.

Les branches extérieures 21a,21b portent respectivement un aimant 23a,23b. À cet effet, les aimants 23a,23b présentent une forme sensiblement plate et s'étendent respectivement le long des branches extérieures 21a,21b.

La branche centrale 21c s'engage dans une ouverture 27 prévue dans le corps de la bobine 25, la branche centrale 21c formant ainsi un support pour l'enroulement de la bobine 25 qui traverse alors successivement les deux champs magnétiques opposés B1 et B2. Cette branche centrale 21c assure ainsi en outre le guidage mécanique de la translation de la partie mobile 11.

Comme l'illustre de façon schématique la figure 4b, l'enroulement de la bobine 25 est selon l'axe longitudinal L de l'actionneur 5a,5b de façon perpendiculaire aux champs magnétiques B1 et B2 créés par les aimants 23a,23b, de manière à générer une translation de la plaque 3 selon la direction D1 ou D2 perpendiculaire à la fois à l'axe longitudinal L et aux champs B1,B2.

En effet, en se référant aux figures 4a et 4b, l'alimentation en courant de la bobine 25 du premier actionneur 5a selon une première direction d perpendiculaire au premier champ magnétique B1 créé par l'aimant 23a, au niveau de la partie supérieure de l'enroulement, génère une force de Laplace F11 perpendiculaire à la fois au premier champ magnétique B1 et à la direction d. De même, l'alimentation en courant de la bobine 25 selon une deuxième direction d' opposée à la première direction d et perpendiculaire au second champ magnétique B2 créé par l'aimant 23b, au niveau de la partie inférieure de l'enroulement, génère une force de Laplace F12 perpendiculaire à la fois au second champ magnétique B2 et à la direction d', Les deux forces de Laplace Fil et F12 générées sont orientées selon une direction d'entraînement commune D1 et sont cumulées de sorte que la force résultante d'actionnement entraîne la partie mobile 11 en translation dans l'entrefer e pour déplacer la plaque 3 selon la direction D1.

Un tel actionneur 5a ou 5b, permet de générer une force d'actionnement alternativement selon deux directions opposées.

De façon similaire, l'alimentation en courant de la bobine 25 du second actionneur 5b permet de déplacer la plaque 3 en translation selon la direction D2, en inversant le sens de circulation du courant dans le second actionneur 5b par rapport au premier actionneur 5a.

Un troisième mode de réalisation illustré sur la figure 5 diffère du second mode de réalisation par le fait que la structure ferromagnétique 21 est portée par la partie fixe 9 de l'actionneur 5a,5b et que la bobine 25 est portée par la partie mobile 11 de l'actionneur 5a,5b.

Dans ce cas, la forme de la plaque 3 est adaptée pour être fixée à la partie mobile 11. Plus précisément, la plaque 3 présente à ses extrémités deux prolongements sur lesquels sont fixées les parties mobiles 11 portant les bobines 25.

Le fonctionnement des actionneurs 5a et 5b reste identique.

On comprend donc qu'un tel dispositif de commande à retour haptique permet d'assurer un retour haptique selon une direction verticale par rapport à la plaque qui soit amplifié sans nécessiter une augmentation de la consommation d'énergie.

## Revendications

1. Dispositif de commande à retour haptique comportant :
- une plaque (3) pour transmettre un retour haptique à un utilisateur,
- un capteur (7) à surface tactile porté par ladite plaque, configuré pour détecter un appui de l'utilisateur sur la surface tactile,
- au moins deux actionneurs (5a,5b) reliés à ladite plaque (3) et configurés pour entraîner ladite plaque (3) en mouvement de manière à générer le retour haptique, et
- une unité de traitement (19) reliée audit capteur (7) et configurée pour piloter simultanément lesdits actionneurs (5a,5b) lorsqu'un appui est détecté sur ladite surface tactile,
lesdits actionneurs (5a,5b) étant respectivement configurés pour entraîner ladite plaque (3) selon une direction (D1,D2) sensiblement perpendiculaire au plan défini par ladite plaque (3) et l'unité de traitement (19) étant configurée pour piloter indépendamment chaque actionneur (5a,5b) en fournissant à chaque actionneur (5a,5b) un signal d'alimentation périodique,
le dispositif de commande étant **caractérisé en ce que** lesdits signaux d'alimentation sont déphasés de 180° de sorte que lesdits actionneurs (5a,5b) entraînent simultanément ladite plaque dans deux directions opposées (D1, D2).

2. Dispositif selon la revendication 1, **caractérisé en ce que** l'unité de traitement (19) est configurée pour piloter indépendamment lesdits actionneurs (5a,5b) en fonction de la position de l'appui détecté par ledit capteur (7).

3. Dispositif selon l'une quelconque des revendications précédentes **caractérisé en ce qu'**il comporte un amortisseur (17) entre ladite plaque (3) et un châssis (13) fixe dudit dispositif (1), pour amortir le mouvement de ladite plaque (3) selon ladite direction (D1,D2) perpendiculaire.

4. Dispositif selon l'une quelconque des revendications précédentes, **caractérisé en ce qu'**au moins un actionneur (5a,5b) est électromagnétique et comporte une partie fixe (9) et une partie mobile (11) reliée à ladite plaque (3), lesdites parties fixe (9) et mobile (11) formant un circuit magnétique définissant au moins un entrefer (e) entre lesdites parties fixe (9) et mobile (11).

5. Dispositif selon la revendication 4, **caractérisé en ce que** ledit actionneur (5a,5b) comporte un moyen de liaison élastique (15) dans l'entrefer (e) entre lesdites parties fixe (9) et mobile (11).

6. Dispositif selon l'une des revendications 4 ou 5, **caractérisé en ce que** ledit actionneur (5a,5b) comporte en outre :
- au moins deux aimants (23a,23b) permanents générant un premier (B1) et un second (B2) champs magnétiques opposés, et
- une bobine (25) disposée entre lesdits aimants (23a,23b) telle que l'enroulement de la bobine (25) traverse successivement lesdits premier (B1) et second (B2) champs magnétiques,
de sorte que lorsque la bobine (25) est parcourue par un courant, ledit actionneur (5a,5b) est soumis à une force résultante d'actionnement selon une direction d'entraînement commune pour entraîner ladite partie mobile (11) en translation dans ledit entrefer (e).

7. Dispositif selon la revendication 6, **caractérisé en ce que** la partie dudit actionneur (5a,5b) portant lesdits aimants (23a,23b) présente une forme générale sensiblement en E, dont les branches extérieures (21a,21b) portent respectivement un aimant permanent (23a,23b) et dont la branche centrale (21c) forme un support pour l'enroulement de la bobine (25).

8. Dispositif selon la revendication 7, **caractérisé en ce que** la partie dudit actionneur (5a,5b) portant la bobine (25) présente une ouverture (27) dans laquelle s'engage ladite branche centrale (21c).

## Patentansprüche

1. Steuervorrichtung mit haptischer Rückkopplung, die Folgendes umfasst:
- eine Platte (3), um eine haptische Rückkopplung an einen Benutzer zu übertragen,
- einen Sensor (7) mit berührungsempfindlicher Oberfläche, der von der Platte getragen wird und dazu konfiguriert ist, einen Druck des Benutzers auf die berührungsempfindliche Oberfläche zu detektieren,
- mindestens zwei Stellglieder (5a, 5b), die mit der Platte (3) verbunden sind und dazu konfiguriert sind, die Platte (3) beweglich anzutreiben, um die haptische Rückkopplung zu erzeugen, und
- eine Verarbeitungseinheit (19), die mit dem Sensor (7) verbunden ist und dazu konfiguriert ist, die Stellglieder (5a, 5b) gleichzeitig anzusteuern, wenn an der berührungsempfindlichen Oberfläche ein Druck detektiert wird,
wobei die Stellglieder (5a, 5b) jeweils dazu konfiguriert sind, die Platte (3) gemäß einer Richtung (D1, D2), die zu der durch die Platte (3) definierten Ebene im Wesentlichen senkrecht ist, anzutreiben, und wobei die Verarbeitungseinheit (19) dazu konfiguriert ist, jedes Stellglied (5a, 5b) unabhängig anzusteuern, indem sie jedem Stellglied (5a, 5b) ein periodisches Versorgungssignal bereitstellt,
wobei die Steuervorrichtung **dadurch gekennzeichnet ist, dass** die Versorgungssignale um 180° phasenverschoben sind, sodass die Stellglieder (5a, 5b) die Platte gleichzeitig in zwei entgegengesetzte Richtungen (D1, D2) antreiben.

2. Vorrichtung nach Anspruch 1, **dadurch gekennzeichnet, dass** die Verarbeitungseinheit (19) dazu konfiguriert ist, die Stellglieder (5a, 5b) in Abhängigkeit von der Position des durch den Sensor (7) detektierten Drucks unabhängig anzusteuern.

3. Vorrichtung nach einem der vorhergehenden Ansprüche, **dadurch gekennzeichnet, dass** sie ein Dämpfungselement (17) zwischen der Platte (3) und einem festen Rahmen (13) der Vorrichtung (1) umfasst, um die Bewegung der Platte (3) gemäß der senkrechten Richtung (D1, D2) zu dämpfen.

4. Vorrichtung nach einem der vorhergehenden Ansprüche, **dadurch gekennzeichnet, dass** mindestens ein Stellglied (5a, 5b) elektromagnetisch ist und einen festen Teil (9) und einen beweglichen Teil (11), der mit der Platte (3) verbunden ist, umfasst, wobei der feste (9) und der bewegliche (11) Teil einen Magnetkreis bilden, der mindestens einen Luftspalt (e) zwischen dem festen (9) und dem beweglichen (11) Teil definiert.

5. Vorrichtung nach Anspruch 4, **dadurch gekennzeichnet, dass** das Stellglied (5a, 5b) ein elastisches Verbindungsmittel (15) in dem Luftspalt (e) zwischen dem festen (9) und dem beweglichen (11) Teil umfasst.

6. Vorrichtung nach einem der Ansprüche 4 oder 5, **dadurch gekennzeichnet, dass** das Stellglied (5a, 5b) ferner Folgendes umfasst:
- mindestens zwei Permanentmagneten (23a, 23b), die ein erstes (B1) und ein zweites (B2) Magnetfeld erzeugen, die einander entgegengesetzt sind, und
- eine Spule (25), die zwischen den Magneten (23a, 23b) angeordnet ist, sodass die Wicklung der Spule (25) nacheinander das erste (B1) und das zweite (B2) Magnetfeld durchquert,
sodass, wenn die Spule (25) von einem Strom durchflossen wird, das Stellglied (5a, 5b) einer resultierenden Betätigungskraft gemäß einer gemeinsamen Antriebsrichtung ausgesetzt ist, um den beweglichen Teil (11) in dem Luftspalt (e) translatorisch anzutreiben.

7. Vorrichtung nach Anspruch 6, **dadurch gekennzeichnet, dass** der Teil des Stellglieds (5a, 5b), der die Magneten (23a, 23b) trägt, im Wesentlichen eine allgemeine E-Form aufweist, deren äußere Arme (21a, 21b) jeweils einen Permanentmagneten (23a, 23b) tragen und deren mittlerer Arm (21c) eine Stütze für die Wicklung der Spule (25) bildet.

8. Vorrichtung nach Anspruch 7, **dadurch gekennzeichnet, dass** der Teil des Stellglieds (5a, 5b), der die Spule (25) trägt, eine Öffnung (27) aufweist, in die der mittlere Arm (21c) eingreift.

## Claims

1. Control device that provides haptic feedback, comprising:
- a plate (3) for transmitting haptic feedback to a user,
- a sensor (7) comprising a touch surface, said sensor being borne by said plate and configured to detect a press of the user on the touch surface,
- at least two actuators (5a, 5b) connected to said plate (3) and configured to drive said plate (3) to move so as to generate the haptic feedback, and
- a processing unit (19) connected to said sensor (7) and configured to simultaneously drive said actuators (5a, 5b) when a press is detected on said touch surface,
said actuators (5a, 5b) respectively being configured to drive said plate (3) in a direction (D1, D2) substantially perpendicular to the plane defined by said plate (3), and the processing unit (19) being configured to independently drive each actuator (5a, 5b) by delivering, to each actuator (5a, 5b), a periodic supply signal, the control device being **characterized in that** said supply signals are out of phase by 180° so that said actuators (5a, 5b) simultaneously drive said plate in two opposite directions (D1, D2).

2. Device according to Claim 1, **characterized in that** the processing unit (19) is configured to independently drive said actuators (5a, 5b) depending on the position of the press detected by said sensor (7).

3. Device according to either one of the preceding claims, **characterized in that** it comprises a damping mechanism (17) between said plate (3) and a fixed casing (13) of said device (1), in order to damp the movement of said plate (3) in said perpendicular direction (D1, D2) .

4. Device according to any one of the preceding claims, **characterized in that** at least one actuator (5a, 5b) is electromagnetic and comprises a fixed portion (9) and a movable portion (11) that is connected to said plate (3), said fixed portion (9) and said movable portion (11) forming a magnetic circuit defining at least one gap (e) between said fixed portion (9) and said movable portion (11) •

5. Device according to Claim 4, **characterized in that** said actuator (5a, 5b) comprises an elastic linking means (15) in the gap (e) between said fixed portion (9) and said movable portion (11).

6. Device according to either of Claims 4 and 5, **characterized in that** said actuator (5a, 5b) furthermore comprises:
- at least two permanent magnets (23a, 23b) that generate a first magnetic field (B1) and a second magnetic field (B2) that are opposite, and
- a coil (25) placed between said magnets (23a, 23b) such that the winding of the coil (25) passes successively through said first and second magnetic fields (B1, B2),
so that when a current flows through the coil (25), said actuator (5a, 5b) is subjected to a resultant actuating force in a common driving direction so as to drive said movable portion (11) translationally in said gap (e).

7. Device according to Claim 6, **characterized in that** the portion of said actuator (5a, 5b) bearing said magnets (23a, 23b) is generally substantially E-shaped, the exterior arms (21a, 21b) of which respectively bear one permanent magnet (23a, 23b) and the central arm (21c) of which forms a holder for the winding of the coil (25).

8. Device according to Claim 7, **characterized in that** the portion of said actuator (5a, 5b) bearing the coil (25) comprises an aperture (27) in which said central arm (21c) is engaged.
